# EUROPEAN PATENT SPECIFICATION

(11) **EP 2 013 382 B1**
(45) Date of publication and mention of the grant of the patent: **03.07.2013**
(21) Application number: 07760126.8
(22) Date of filing: 04.04.2007
(51) Int. Cl.: G01B 21/08, H01L 31/0392, C25D 5/10, C25D 7/06, C25D 21/12

(54) **COMPOSITION CONTROL FOR ROLL-TO- ROLL PROCESSED PHOTOVOLTAIC FILMS**
ZUSAMMENSETZUNGSSTEUERUNG FÜR ROLLE-ZU-ROLLE-FERTIGUNG VON PHOTOVOLTAIKFOLIEN
RÉGULATION DE COMPOSITION POUR FILMS PHOTOVOLTAÏQUES TRAITÉS PAR DÉPÔT DE ROULEAU À ROULEAU

(30) Priority: 04.04.2006 US 744252 P; 15.11.2006 US 560321
(43) Date of publication of application: 14.01.2009
(73) Proprietor: SoloPower, Inc., Milpitas CA 95035 (US)
(72) Inventor: BASOL, Bulent, Manhattan Beach, CA 90266 (US); AKSU, Serdar, Santa Clara, CA 95054 (US)
(74) Representative: Freeman, Avi
(86) International application number: PCT/US2007/065991
(87) International publication number: WO 2007/115318

(56) References cited:
- WO-A2-2005/089330
- US-A- 4 581 108
- US-A- 4 659 437
- US-A- 5 326 455
- US-A- 5 326 455
- US-A- 6 099 709
- US-B1- 6 428 673
- D. LINGOT ET AL.: "Chalcopyrite thin film solar cells by electrodeposition", SOLAR ENERGY, vol. 77, 30 October 2004 (2004-10-30), - 30 October 2004 (2004-10-30), pages 725-737, XP002675569, DOI: 10.1016/j.solener.2004.05.024
- KAMPMANN A. ET AL.: 'Electrodeposition of CIGS on Metal Substrates' MAT. RES. SOC. SYMP. vol. 763, 2003, XP009081441
- BASOL B.M. ET AL.: 'Modules and Flexible Cells of CuInSe2' CONFERENCE RECORD OF THE TWENTY-THIRD IEEE PHOTOVOLTAIC SPECIALISTS CONFERENCE 1993, page 426

## Description

This application claims priority to US provisional application number 60/744,252 filed April 4, 2006 and to US utility application number 11/560,321 filed November 15, 2006.

### Field of the Invention

The present invention relates to methods and apparatus for preparing thin films of Group IBIIIAVIA compound semiconductor films for radiation detector and photovoltaic applications.

### Background

Solar cells are photovoltaic devices that convert sunlight directly into electrical power. The most common solar cell material is silicon, which is in the form of single or polycrystalline wafers. However, the cost of electricity generated using silicon-based solar cells is higher than the cost of electricity generated by the more traditional methods. Therefore, since early 1970's there has been an effort to reduce cost of solar cells for terrestrial use. One way of reducing the cost of solar cells is to develop low-cost thin film growth techniques that can deposit solar-cell-quality absorber materials on large area substrates and to fabricate these devices using high-throughput, low-cost methods.

Group IBIIIAVIA compound semiconductors comprising some of the Group IB (Cu, Ag, Au), Group IIIA (B, Al, Ga, In, Tl) and Group VIA (O, S, Se, Te, Po) materials or elements of the periodic table are excellent absorber materials for thin film solar cell structures. Especially, compounds of Cu, In, Ga, Se and S which are generally referred to as CIGS(S), or Cu(In,Ga)(S,Se)₂ or Culn₁₋ₓGaₓ (SySe_{1-y})ₖ , where 0≤x≤1, 0≤y≤1 and k is approximately 2, have already been employed in solar cell structures that yielded conversion efficiencies approaching 20%. Absorbers containing Group IIIA element Al and/or Group VIA element Te also showed promise. Therefore, in summary, compounds containing: i) Cu from Group IB, ii) at least one of In, Ga, and Al from Group IIIA, and iii) at least one of S, Se, and Te from Group VIA, are of great interest for solar cell applications.

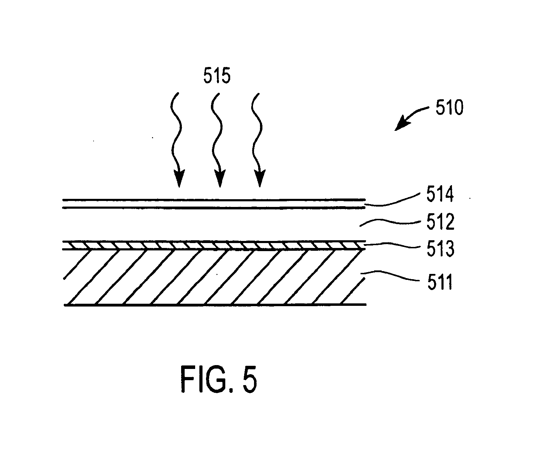

The structure of a conventional Group IBIIIAVIA compound photovoltaic cell such as a Cu(In,Ga,Al)(S,Se,Te)₂ thin film solar cell is shown in Fig. 5. The device 510 is fabricated on a base which includes a substrate 511 coated with a conductive layer 513. The substrate 511 may be in various forms and shapes, such as a sheet of glass, a sheet of metal (such as aluminum or stainless steel), an insulating foil or web, or a conductive foil or web. The absorber film 512, which comprises a material in the family of Cu(In,Ga,Al)(S,Se,Te)₂, is grown over the conductive layer 513, which is previously deposited on the substrate 511 and which acts as the electrical contact to the device. Various conductive layers comprising Mo, Ta, W, Ti, and stainless steel etc. have been used in the solar cell structure of Fig. 5. If the substrate itself is a properly selected conductive material, it is possible not to use a conductive layer 513, since the substrate 511 may then be used as the ohmic contact to the device. After the absorber film 512 is grown, a transparent layer S14 such as a CdS, ZnO or CdS/ZnO stack is formed on the absorber film. Radiation 515 enters the device through the transparent layer 514. Metallic grids (not shown) may also be deposited over the transparent layer 514 to reduce the effective series resistance of the device. It should be noted that the structure of Fig. 5 may also be inverted if substrate is transparent. In that case light enters the device from the substrate side of the solar cell.

In a thin film solar cell employing a Group IBIIIAVIA compound absorber, the cell efficiency is a strong function of the molar ratio of IB/IIIA. If there are more than one Group IIIA materials in the composition, the relative amounts or molar ratios of these IIIA elements also affect the properties. For a Cu(In,Ga)(S,Se)₂ absorber layer, for example, the efficiency of the device is a function of the molar ratio of Cu/(In+Ga). Furthermore, some of the important parameters of the cell, such as its open circuit voltage, short circuit current and fill factor vary with the molar ratio of the IIIA elements, i.e. the Ga/(Ga+In) molar ratio. In general, for good device performance Cu/(In+Ga) molar ratio is kept at around or below 1.0. As the Ga/(Ga+In) molar ratio increases, on the other hand, the optical bandgap of the absorber layer increases and therefore the open circuit voltage of the solar cell increases while the short circuit current typically may decrease. It is important for a thin film deposition process to have the capability of controlling both the molar ratio of IB/IIIA, and the molar ratios of the Group IIIA components in the composition. It should be noted that although the chemical formula is often written as Cu(In,Ga)(S,Se)₂, a more accurate formula for the compound is Cu(In,Ga)(S,Se)ₖ, where k is typically close to 2 but may not be exactly 2. For simplicity we will continue to use the value of k as 2. It should be further noted that the notation "Cu(X,Y)" in the chemical formula means all chemical compositions of X and Y from (X=0% and Y=100%) to (X=100% and Y=0%). For example, Cu(In,Ga) means all compositions from Culn to CuGa. Similarly, Cu(In,Ga)(S,Se)₂ means the whole family of compounds with Ga/(Ga+ln) molar ratio varying from 0 to 1, and Se/(Se+S) molar ratio varying from 0 to 1.

The first technique used to grow Cu(In,Ga)Se₂ layers was the co-evaporation approach which involves evaporation of Cu, In, Ga and Se from separate evaporation boats onto a heated substrate, as the deposition rate of each component is carefully monitored and controlled.

Another technique for growing Cu(In,Ga)(S,Se)₂ type compound thin films for solar cell applications is a two-stage process where at least two of the components of the Cu(In,Ga)(S,Se)₂ material are first deposited onto a substrate, and then reacted with S and/or Se in a high temperature annealing process. For example, for CuInSe₂ growth, thin sub-layers of Cu and In are first deposited on a substrate to form a precursor layer and then this stacked precursor layer is reacted with Se at elevated temperature. If the reaction atmosphere contains sulfur, then a CuIn(S,Se)₂ layer can be grown. Addition of Ga in the precursor layer, i.e. use of a Cu/In/Ga stacked film precursor, allows the growth of a Cu(In,Ga)(S,Se)₂ absorber. Other prior-art techniques include deposition of Cu-Se/In-Se, Cu-Se/Ga-Se, or Cu-Se/In-Se/Ga-Se stacks and their reaction to form the compound. Mixed precursor stacks comprising compound and elemental sub-layers, such as a Cu/In-Se stack or a Cu/In-Se/Ga-Se stack, have also been used, where In-Se and Ga-Se represent selenides of In and Ga, respectively.

Sputtering and evaporation techniques have been used in prior art approaches to deposit the individual layers or sub-layers containing the Group IB and Group IIIA components of metallic precursor stacks. In the case of CuInSe₂ growth, for example, Cu and In sub-layers were sequentially sputter-deposited from Cu and In targets on a substrate and then the stacked precursor layer or film thus obtained was heated in the presence of gas containing Se at elevated temperatures as described in U.S. 4,798,660. More recently U.S. Patent 6,048,442 disclosed a method comprising sputter-depositing a stacked precursor film comprising a Cu-Ga alloy sub-layer and an In sub-layer to form a Cu-Ga/In stack on a metallic back electrode and then reacting this precursor stack film with one of Se and S to form the compound absorber layer. U.S. Patent 6,092,669 described sputtering-based equipment and method for producing such absorber layers.

Solar cell structures are typically fabricated on glass or metallic foil substrates. For monolithically integrated modules glass sheets are commonly used, whereas metallic foils are more suitable for fabrication of individual cells that may be later interconnected into modules. It is, of course, possible to deposit an insulating layer over the metallic foil substrate and then process solar cells on the insulating layer. This way, monolithically integrated modules may also be fabricated on metallic foil substrates.

Irrespective of the specific approach used to grow a Cu(In,Ga)(S,Se)₂ absorber film, two molar ratios mentioned before, i.e. the Cu/(In+Ga) ratio and the Ga/(Ga+In) ratio, should be closely controlled from run to run and on large area substrates. In co-evaporation techniques, this composition control is achieved through in-situ monitoring of the evaporation rates of Cu, In, Ga and Se. In two-stage techniques, which involve deposition of sub-layers to form a precursor film and then reaction of the precursor film to form the compound absorber layer, individual thicknesses of the sub-layers forming the stacked precursor film layer need to be well controlled because they determine the final stoichiometry or composition of the compound layer after the reaction step. If the sub-layers are deposited by vacuum approaches, such as evaporation and sputtering, thicknesses of the sub-layers within the precursor layer (such as thicknesses of Cu and In sub-layers) may be monitored and controlled using in-situ measurement devices such as crystal oscillators, or sensors that sense the material deposition flux. In the prior art electroplating techniques, on the other hand, thickness of individual sub-layers such as the Cu sub-layer, In sub-layer, and/or Ga sub-layer have been controlled through control of the charge passed during deposition of the sub-layer, i.e. through control of the deposition current density and the deposition time. However, during processing, it is possible that deposition rates change. For example, in electrodeposition approach the deposition rates may vary due to reasons such as a change in the electrodeposition efficiency, age of the deposition bath, accumulation of byproducts in the bath, change in organic or inorganic additive concentrations and/or activities etc. in the electrolyte. Since solar cell efficiency is a strong function of the molar ratios of the elements within the deposited precursors, new techniques that assure excellent control of these ratios are needed.

Deposition or growth of layers forming a thin film solar cell in a roll-to-roll or in-line process is attractive for higher throughput, lower cost and better yield of such approaches. There is still need to develop roll-to-roll or in-line deposition techniques for the growth of Group IBIIIA VIA materials wherein the critical IB/IIIA molar ratio as well as the IIIA material composition are tightly controlled.

### Summary Of The Invention

According to the present invention there is provided a method of electroplating a stacked layer of a plurality of films in a plurality of sequentially disposed electroplating units onto a continuously moving roll-to-roll sheet comprising the steps of: continuously moving the roll-to-roll sheet through each of the plurality of sequentially disposed electroplating units so that continuous portions of a top surface of the roll-to-roll sheet are positioned for electroplating to occur thereover when disposed in each of the electroplating units; continuously electroplating each one of the films over the top surface of the roll-to-roll sheet using each of the electroplating units as the roll-to-roll sheet moves therethrough, wherein the plurality of films include Cu, In and Ga elements; and detecting a thickness and/or the composition of at least one of the films electroplated over a portion of the roll-to-roll sheet and generating a thickness signal corresponding thereto; wherein the step of continuously electroplating includes adjusting the thickness of each of the films toward a predetermined thickness value for that film using the thickness signal for that film for a subsequent portion of the roll-to-roll sheet that follows the portion of the roll-to-roll sheet, wherein the step of continuously electroplating adjusts the thickness of each of the films toward the predetermined thickness value for that film using the thickness signal for that film for the subsequent portion of the roll-to-roll sheet that follows the portion of the roll-to-roll sheet; and wherein the step of detecting the thickness detects the thickness of each of the films.

The present invention relates to methods and apparatus for providing composition control to thin films of compound semiconductor films for radiation detector and photovoltaic applications.

In one aspect of the invention, there is provided a method in which the molar ratio of the elements in a plurality of layers are detected so that tuning of the multi-element layer can occur to obtain the multi-element layer that has a predetermined molar ratio range.

In another aspect of the invention, there is provided a method in which the thickness of a sub-layer and layers thereover of Cu, In and/or Ga are detected and tuned in order to provide tuned thicknesses that are substantially the same as pre-determined thicknesses.

In another aspect, the present invention provides methods of electroplating a film or films onto a top surface of a continuously moving roll-to-roll sheet.

In another aspect, the invention includes continuously electroplating a film onto a conductive surface using an electroplating unit as the roll-to-roll sheet moves therethrough, detecting a thickness of the film electroplated onto a portion of the roll-to-roll sheet and generating a thickness signal corresponding thereto. In this aspect, when continuously electroplating, the thickness of the film is adjusted toward a predetermined thickness value using the thickness signal for a subsequent portion of the roll-to-roll sheet that follows the portion of the roll-to-roll sheet.

In another aspect there is provided a method of electroplating a stacked layer of a plurality of films in a plurality of sequentially disposed electroplating units onto a continuously moving roll-to-roll sheet. In this aspect, there is included continuously electroplating each one of the films onto a top surface of the roll-to-roll sheet using each of the electroplating units as the roll-to-roll sheet moves therethrough, detecting a thickness of each of the films electroplated onto a portion of the roll-to-roll sheet and generating a thickness signal corresponding thereto. In this aspect, when continuously electroplating the thickness of each of the films is adjusted toward a predetermined thickness value for that film using the thickness signal for that film for a subsequent portion of the roll-to-roll sheet that follows the portion of the roll-to-roll sheet.

In yet another aspect, there is included continuously electroplating a first film onto a top surface of the continuously moving roll-to-roll sheet; detecting a thickness of the first film and generating a thickness signal corresponding thereto; and continuously electroplating a second film over the first film, wherein a thickness of the electroplated second film is controlled by the thickness signal.

In a still further aspect, when detecting the thickness of an electroplated film, the thickness is detected at a plurality of locations across a width of the continuously moving roll-to-roll sheet to obtain a corresponding plurality of thickness signals. These plurality of thickness signals are used to adjust a thickness of the same film or a subsequent film, such that the thickness is adjusted taking into consideration the location of the detecting.

### Brief Description of the Drawings

These and other aspects and features of the present invention will become apparent to those of ordinary skill in the art upon review of the following description of specific embodiments of the invention in conjunction with the accompanying figures, wherein:

FIG. 1 is a representation of the process steps of one embodiment.

FIG. 2A shows a cluster tool configuration with various chambers around a central handler.

FIG. 2B shows an in-line tool configuration with composition control capability in accordance with one embodiment of the invention.

FIG. 3 shows an integrated deposition station/metrology station pair.

FIG. 4 shows a roll-to-roll electrodeposition system employing at least one deposition station, at least one metrology station and at least one tuning station.

FIG. 5 is a cross-sectional view of a solar cell employing a Group IBIIIAVIA absorber layer.

FIG. 6 is a schematic of a roll-to-roll electroplating system to deposit a precursor layer that may be used for the formation of a Group IBIIIAVIA absorber layer.

FIG. 7A is a flexible foil base.

FIG. 7B is a flexible foil base with an electroplated Cu/Ga/In precursor stack.

FIG. 8 shows a side view of a roll-to-roll electrodeposition system comprising a Cu-processing-unit, a Ga-processing-unit, and an In-processing-unit with their associated metrology-stations.

FIG. 9 shows a top view of a Cu-processing-unit and a Cu-metrology-station.

### Detailed Description

The present invention overcomes the shortcomings of the prior art techniques by addressing the important manufacturability and yield issues associated with poor control of the stoichiometry or composition of Group IBIIIAVIA semiconductor layers. The technique is generally applicable to all techniques used to grow Group IBIIIAVIA semiconductor layers. It is specifically well suited to control the composition of layers grown using a two-stage technique.

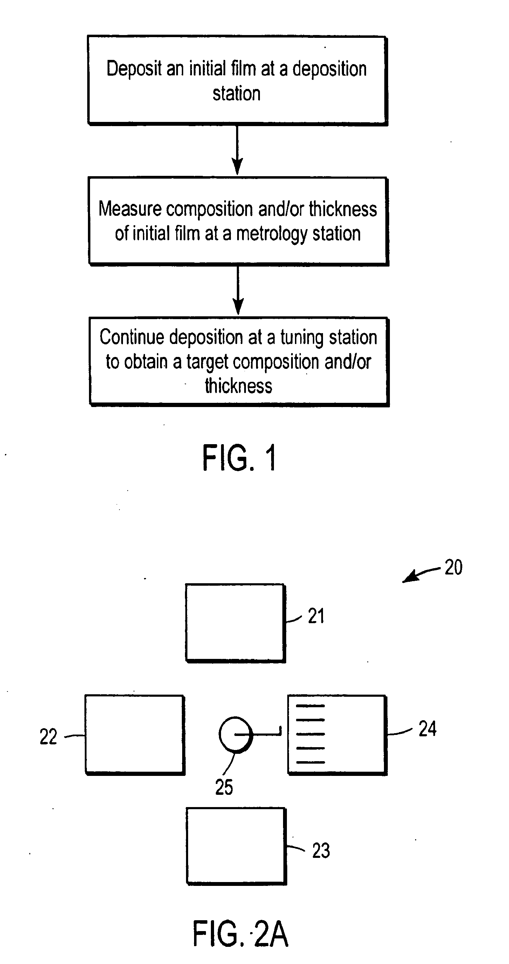

Figure 1 shows the steps of carrying out the process of the present invention. The process comprises at least three steps. In the first step an initial film comprising at least one of a Group IB, a Group IIIA, and a Group VIA material is deposited on at least a portion of a substrate at a deposition station. In the second step the composition and/or thickness of the initial film on the portion of the substrate is measured in a metrology station. In the third step, based on the information from the second step, an additional film is deposited on the portion at a tuning station to bring the composition and/or thickness of the total film to a target value, wherein the total film is defined as the sum of the initial film and the additional film. These three steps may then be repeated for better accuracy in reaching the target value. The deposition processes carried out at the deposition station(s) and at the tuning station(s) may be selected from a variety of techniques such as evaporation, sputtering, electroplating, electroless plating, ink deposition, melt deposition etc. These techniques may be mixed also. For example, an evaporation technique may be used in the deposition station and an electroplating technique may be used in the tuning station. Furthermore, there may be more than one deposition station and more than one tuning station to first deposit the initial layer and then to bring the composition/thickness of the total film to the target value. Various measurement methods may be used at the metrology station(s). These methods include, but are not limited to X-ray fluorescence, X-ray diffraction, X-ray reflectance, profile thickness measurement, optical reflectance, ellipsometry, 4-point probe measurement etc.

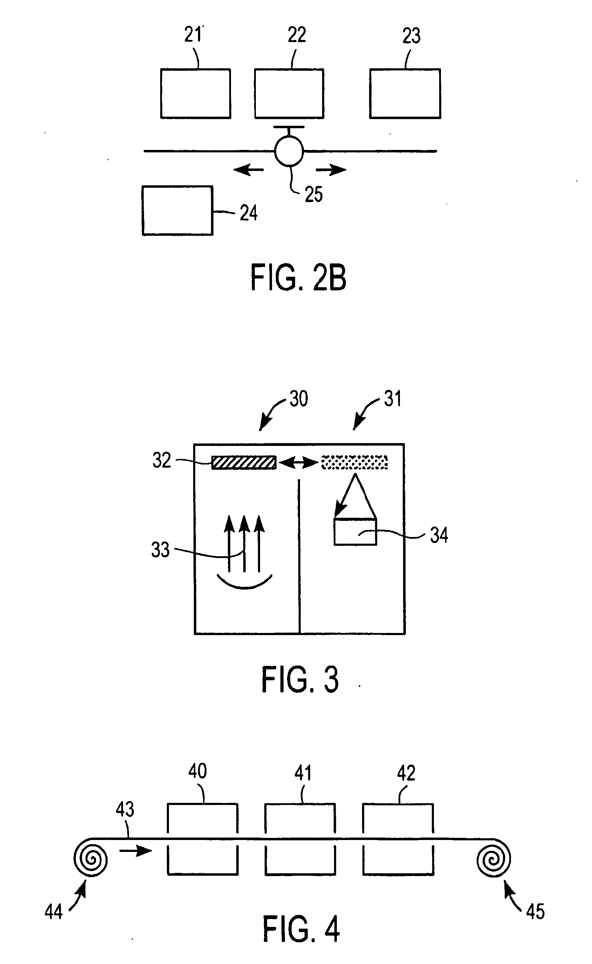

The deposition station(s), metrology station(s) and tuning station(s) may be placed in a system in various configurations. For example, Figure 2A shows a cluster-tool 20 configuration including a deposition station 21, a metrology station 22, a tuning station 23, a load-unload station 24 and a handler 25 to transport the substrates between various stations. It should be noted that one or more deposition stations, one or more metrology stations, one or more tuning stations, one or more load-unload stations, as well as one or more other stations such as cleaning and/or drying stations, heating stations, reaction stations etc. may also be added to the cluster-tool 20 of Figure 2.

The deposition station(s) 21, metrology station(s) 22, tuning station(s) 23 and load-unload station(s) 24 may also be placed in-line manner as shown in Figure 2B and the handler 25 move linearly to move the substrates between various stations.

In one embodiment the deposition station and the tuning station are two different stations. In other words, after an initial film is deposited on a substrate at a deposition station and then measured at a metrology station, an additional film is deposited over the initial film at a tuning station that is different from the deposition station. Alternately, the deposition station and the tuning station may be the same station. For example, an initial film may be deposited on a substrate at a deposition station. The substrate may then be moved to a metrology station for measurement of the initial film. Then the substrate may be moved back to the same deposition station to deposit an additional film over the initial film and to achieve the target values of thickness and/or composition. In this case the deposition station acts as a tuning station when the substrate is moved into it for the second time. As stated before, it is possible that substrate goes through more than one deposition stations before arriving at the metrology station. It may then be moved to more than one tuning stations to achieve the target composition and/or thickness of the deposited total film. Metrology stations may also be more than one, each measuring a different important parameter, for example one measuring composition and another one measuring thickness.

A specific configuration where the deposition station and the tuning station are the same is schematically shown in Figure 3. The configuration in Figure 3 comprises a deposition station 30 and a metrology station 31. A substrate 32 is first placed in the deposition station 30 and an initial film is deposited onto the substrate 32 as schematically indicated by arrows 33. Then, as shown by the dotted lines, the substrate 32 is moved into the metrology station 31 and measurements are carried out on the initial film using a metrology tool 34. The substrate 32 is then moved back into the deposition station 30 to further deposit an additional film so that a target total film thickness and/or composition is reached.

In another embodiment, the present invention may be used in controlling the composition of a precursor layer employed in a two-stage method where during the first stage of the process sub-layers comprising at least one of a Group IB, a Group IIIA and a Group VIA material are deposited on a substrate to form the precursor layer, and during the second stage a reaction is carried out to convert the precursor layer into a Group IBIIIAVIA compound layer. In this case the sub-layer deposition process is divided into at least two deposition steps and a measurement step is provided between the at least two deposition steps. The first deposition step deposits an initial sub-layer. If the deposited sub-layer comprises only one element, the measurement step measures the thickness of the initial sub-layer. If the deposited sub-layer comprises more than one element, such as an alloy, the measurement step may measure the effective thickness of each element or it may measure the composition of the sub-layer. The subsequent deposition step(s) after the measurement step then are used to bring the total thickness or the composition of the sub-layer to a targeted value. The invention will now be described using various examples.

### Example 1.

A Cu(In,Ga)Se2 compound layer with a Cu/(In+Ga) ratio of 0.95 and Ga/(Ga+In) ratio of 0.3 may be grown using the present invention by first depositing a Cu/In/Ga precursor stack on a substrate and then reacting the stack with selenium, i.e. by selenizing the stack. It is straight forward to calculate that if the thickness of the Cu sub-layer in the stack is 200 nm, an In sub-layer thickness of 325 nm and a Ga sub-layer thickness of 104 nm would be needed to provide the target composition defined above. In processing such a precursor stack, the following steps may be carried out: i) a nominally 200nm thick Cu sub-layer may be first deposited on at least one portion of a substrate at a first deposition station using optimized conditions and in-situ thickness control means, ii) deposited Cu sub-layer thickness on the portion of the substrate may be determined at a metrology or measurement station, iii) if the thickness measured is within an acceptable range (such as within +/- 5%) of the desired 200 nm, the portion may be moved to another process station to continue with In deposition, iv) if the thickness measured is outside the desired range, the portion may be moved to tuning station to adjust the thickness to the desired range, v) the above steps may be repeated for In deposition and Ga deposition.

It should be noted that the approach of the present invention may be used for the deposition of all the sub-layers or only for sub-layers for which deposition thickness control is difficult, unstable or non-optimized. For example, the approach of the present invention may be used for the deposition of the Cu and Ga sub-layers and may not be used for the deposition of the In sub-layer if the deposition method for the In sub-layer offers already a good thickness control.

### Example 2.

Let us now take, as an example, an electroplating technique used to manufacture Cu/In/Ga precursor stacks on a large number of substrates, such as hundreds or thousands of substrates which may each be 1 ftx1ft or 1ftx4ft in size. Starting with a fresh Cu plating solution or electrolyte, it may be possible to deposit accurately the 200 nm thick Cu layer on the substrates early in the process by applying a pre-determined current density for a pre-determined time. As more and more substrates are electroplated, however, the electrolyte may start to age and the plating efficiency of Cu may drop from its initial value, which may be in the range of 70-100% depending on the chemistry used. Therefore, although the early substrates receive nominally 200 nm thick Cu, the Cu thickness on later substrates may start to decrease. If this reduction of Cu thickness goes un-detected and if the In and Ga thicknesses are accurate, the Cu/(In+Ga) molar ratio in the precursor stack would be lower than the targeted value which, for example may be around 0.95. This would lower the yields once the precursors are converted into Cu(In,Ga)Se2 compound layers and solar cells are fabricated on the compound layers. To avoid this problem, the method of the present invention measures at a metrology station the thickness of the deposited Cu layer, and if the thickness is reduced from the target value, sends the substrate to a tuning station to electroplate more Cu. As an example, let us assume that the Cu thickness for substrate #100 is reduced down to 160 nm although under the same plating conditions substrate #1 had a plated Cu thickness of 200 nm. When the Cu thickness is measured to be 160 nm for substrate # 100, this substrate is forwarded to a tuning station, which may be another Cu plating station, and additional 40 nm of Cu plating is carried out. It should be noted that for better accuracy more metrology steps and tuning steps may be added to the process. In any case, use of the tuning station(s) provides excellent composition control of the precursor stack in a production environment where a large number of substrates are processed in a continuous manner. Similar approaches may be used for the deposition of the other components of the stack such as the In and/or Ga sub-layers. Metrology may be carried out on every substrate or at certain intervals, for example for every 10th substrate. Computer systems may be used to collect the metrology data and trends of thickness behavior may be established. This data may then be used to predict thickness as a function of the bath age. It can also be advantageous to use different baths for deposition and tuning, which deposition and tuning may use electroplating if material is being added.

### Example 3.

In a two-stage process employing an electrodeposited Cu-Ga/In precursor stack, the process may be carried out as follows: A Cu-Ga alloy may be first deposited on a substrate in the form of an initial film at a deposition station. The substrate may then be moved to a metrology station to determine the molar Cu and Ga content in this initial film. If more Cu is needed to reach the target composition, the substrate may be forwarded to a tuning station that deposits more Cu on the initial film. If more Ga is needed to reach the target composition, the substrate may be forwarded to a tuning station that deposits more Ga on the initial film. Once the Cu and Ga contents are brought to a targeted range an In sub-layer may be deposited to form the precursor stack. Indium sub-layer deposition may also be divided into at least two steps. In the first step an In initial film may be deposited over the Cu and Ga containing sub-layer. At a metrology station In content may be measured. Then at a tuning station In content may be brought to a targeted range. This way Cu, In and Ga content of the precursor stack may be brought to the pre-determined desired range.

### Example 4.

The method of the present invention may be used in a cluster tool approach where single substrates, such as pre-cut glass substrates, are coated with the precursor layers. Alternately, the invention may also be used in an in-line processing approach such as a roll-to-roll processing technique.

A Cu(In,Ga)Se2 compound layer with a Cu/(In+Ga) ratio of 0.95 and Ga/(Ga+In) ratio of 0.3 may be grown using the present invention by first electrodepositing a Cu/In/Ga precursor stack on a flexible foil substrate and then reacting the stack with selenium, i.e. by selenizing the stack. It is straight forward to calculate that if the thickness of the Cu sub-layer in the stack is 200 nm, an In sub-layer thickness of 325 nm and a Ga sub-layer thickness of 104 nm would be needed to provide the target composition defined above. In processing such a stack, the foil substrate may be in the form of a roll. The Cu, In, and Ga layers may be deposited on the substrate in a roll-to-roll fashion. All depositions may be carried out in a single machine with Cu, In and Ga electroplating stations. They may alternately be carried out in two different machines, one tool electroplating two of the elements (such as Cu and In, Cu and Ga, or In and Ga) and the other tool depositing the third element. Alternately Cu deposition, In deposition and Ga deposition may be carried out in three different roll-to-roll plating machines or tools.

Figure 4 schematically shows an in-line, roll-to-roll Cu electroplating system comprising a deposition station 40, a metrology station 41 and a tuning station 42. As the flexible foil substrate 43 is moved from the supply spool 44 to the receiving spool 45, it gets plated by Cu. The movement of the foil substrate may be continuous or it may be step-wise to plate the substrate with Cu one section at a time. At any time during processing, the deposition station 40 may be activated to carry out electrodeposition of an initial Cu film on the portion of the foil substrate 43 that is within the deposition station 40. The tuning station 42 may not be ordinarily activated, i.e. it does not deposit Cu, unless it gets a signal from the metrology station 41. If and when metrology station senses a change in the Cu target thickness at a portion of the foil substrate 43, a signal is sent to the tuning station through a computer which determines the amount of additional Cu deposition to be carried out on the portion at the tuning station 4w2. Since the movement of the foil substrate 43 from left to right is controlled, the position of the portion at any time is also known. Therefore, when the portion moves into the tuning station 42 the plating cell is activated through application of a voltage between the foil substrate and an anode and the pre-determined additional Cu amount may be deposited on the portion. Subsequent to this the deposition conditions at the deposition station 40 and tuning station 42 may be kept constant until a new measurement is carried out at the metrology station 41 and the deposition condition at the tuning station is adjusted again to meet the target final Cu thickness on the substrate.

It should be noted that, in the embodiment discussed above, thickness measurement results from the metrology station are used to adjust the deposition conditions, such as the deposition current and/or voltage, at the tuning station, keeping the conditions constant at the deposition station. It is also possible that results from the metrology station may be interpreted by a computer to adjust the deposition conditions at the deposition station or both at the deposition station and the tuning station. For example, if the thickness of the initial Cu film deposited at the deposition station 40, as detected by the measurement at the metrology station 41, is low, then the deposition conditions at the deposition station 40 may be adjusted e.g. the deposition current density may be increased, so that future portions of the substrate 43 to be plated receive a Cu thickness that is closer to the target value. It is also possible to remove material, rather than deposit material, at the tuning station. For example, in wet processing such as electroplating, the tuning station may have an electrode in a solution and means to apply a voltage between the electrode and the surface of the substrate when the surface of the substrate is wetted by the solution. For deposition, a negative or cathodic voltage is applied to the substrate surface with respect to the electrode. This way, Cu, In or Ga may be deposited or plated on the substrate surface if the solution contain Cu, In or Ga species. If, on the other hand an anodic or positive voltage is applied to the substrate surface with respect to the electrode already deposited material may be anodically dissolved from the substrate surface. For example, if the deposition station 40 in Figure 4 deposits Cu on the substrate 43, and if the metrology station 41 detects that the thickness of the deposited Cu is more than a target thickness, then when that portion of the substrate enters the tuning station 42, an anodic removal step may be carried out to bring the thickness to the targeted value. Cu removal rate and amount may be controlled by the current density applied between the substrate surface and the electrode in the tuning station.

The processes described for Cu deposition may also be carried out for the In and Ga depositions and a precursor stack comprising Cu, Ga and In may be produced with well defined stoichiometry or composition.

Once the precursor layers of the present invention are deposited reaction of the precursors with Group VIA materials may be achieved various ways. In one embodiment the precursor layer is exposed to Group VIA vapors at elevated temperatures. These techniques are well known in the field and they involve heating the precursor layer to a temperature range of 350-600 °C in the presence of at least one of Se vapors, S vapors, and Te vapors provided by sources such as solid Se, solid S, solid Te, H2Se gas, H2S gas etc. for periods ranging from 5 minutes to 1 hour. In another embodiment a layer or multi layers of Group VIA materials are deposited on the precursor layer and the stacked layers are then heated up in a furnace or in a rapid thermal annealing furnace and like. Group VIA materials may be evaporated on, sputtered on or plated on the precursor layer. Alternately inks comprising Group VIA nano particles may be prepared and these inks may be deposited on the precursor layers to form a Group VIA material layer comprising Group VIA nano particles. Dipping, spraying, doctor-blading or ink writing techniques may be employed to deposit such layers. Reaction may be carried out at elevated temperatures for times ranging from 1 minute to 30 minutes depending upon the temperature. As a result of reaction, the Group IBIIIAVIA compound is formed from the precursor.

Solar cells may be fabricated on the compound layers of the present invention using materials and methods well known in the field. For example a thin (<0.1 microns) CdS layer may be deposited on the surface of the compound layer using the chemical dip method. A transparent window of ZnO may be deposited over the CdS layer using MOCVD or sputtering techniques. A metallic finger pattern is optionally deposited over the ZnO to complete the solar cell.

The present invention provides in another aspect methods and apparatus to control the composition of precursor films or layers, which may be used in the formation of CIGS(S) type absorber layers, through an in-line or roll-to-roll manufacturing approach. The techniques may be used for the deposition of Group IB and Group IIIA materials and optionally Group VIA materials on a base to form precursor layers which are then converted into Group IBIIIAVIA compound layers by annealing at elevated temperatures, preferably in presence of additional Group VIA material(s). Deposition of Group IB, Group IIIA and Group VIA materials may be performed by various techniques such as evaporation, sputtering, spraying, doctor blading, printing, electrodeposition etc., and the processing system may be an in-line-system or a roll-to-roll system wherein layers or sub-layers of Group IB-containing, Group IIIA-containing and Group VIA-containing materials are deposited onto the base consecutively, one after another, at a pre-determined sequence. A preferred method of deposition for the present invention is electrodeposition or electroplating and a preferred processing approach is a roll to roll technique, also referred to as a reel-to-reel technique, as will be discussed in more detail below.

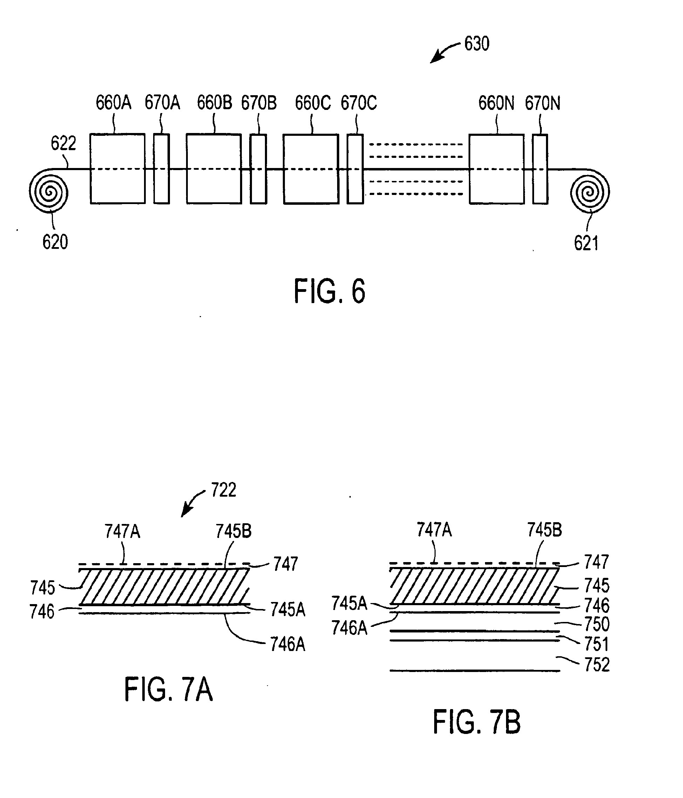

Fig. 6 shows an exemplary roll-to-roll electroplating system 630 with capability to produce, on a flexible foil base 622, a precursor stack comprising Cu, and at least one of In and Ga with excellent thickness control and uniformity. The electroplating system 630 comprises a series of process-units, 660A, 660B, 660C .....660N, one or more metrology-stations 670A, 670B, 670C.... 670N, a supply spool 620, a return spool 621 and a mechanism to direct the flexible foil base 622 from the supply spool 620 to the return spool 621 through the series of process-units. The series of process-units may comprise at least one Cu electroplating unit, and at least one of a Ga electroplating unit and at least one In electroplating unit. Each process-unit may additionally comprise an integrated cleaning or a cleaning/drying unit so that as the flexible foil base 622 exits one process unit such as the process-unit 660A of Fig. 6, and enters a metrology-unit such as the metrology unit 70A, it is clean of any chemical residues that may be introduced in the process-unit 660A.

It should be noted that the number and order of the process-units may be changed to obtain various stacks comprising Cu, In and Ga on the base. For example, if there were only three process-units; 660A, 660B and 660C in the system of Fig. 6, and if the process-units 660A, 660B and 660C comprise a Cu electroplating unit, an In electroplating unit, and a Ga electroplating unit, respectively, then the system would yield a Cu/In/Ga precursor stack on the flexible foil base 622. Changing this order and optionally adding other electroplating units, one may obtain stacks such as Cu/Ga/In, In/Cu/Ga, Ga/Cu/In, Cu/Ga/Cu/In, Cu/Ga/Cu/In/Cu, Cu/In/Cu/Ga, Cu/In/Cu/Ga/Cu etc. By adding process-units with ability to electroplate a Group VIA material such as Se, precursor stacks comprising Se may also be obtained. Such stacks include but are not limited to Cu/In/Ga/Se, In/Cu/Ga/Se, Ga/Cu/In/Se, Cu/Ga/Cu/In/Se, Cu/Ga/Cu/In/Cu/Se, Cu/In/Cu/Ga/Se, Cu/In/Cu/Ga/Cu/Se etc. It should be noted that many more iterations of such stacks are possible. We will, however, continue our discussion using a roll-to-roll electroplating system configuration comprising one of each of a Cu electroplating unit, a Ga electroplating unit and an In electroplating unit, with their integrated or associated cleaning units. It should be noted that the system depicted in Fig. 6 may have other components such as annealing units, conditioning units for cleaning and chemical conditioning the flexible foil base 622 before the first process unit 660A, etc. A preferred structure of the flexible foil base 622 supplied by the supply spool 620 is shown in Fig. 7A as flexible foil base 722. The flexible foil base 722 comprises a flexible foil substrate 745 and a conductive layer 746 or a contact layer deposited on a first surface 745A of the flexible foil substrate 745. The flexible foil substrate 745 may be made of any polymeric (such as polyimide) or metallic foil, but preferably it is a metallic foil such as a 20-250 um thick stainless steel foil, Mo foil, Ti foil, Al or Al-alloy foil. Various metallic foil substrates (such as Cu, Ti, Mo, Ni, Al) have previously been identified for CIGS(S) solar cell applications (see for example, B.M. Basol et al., "Status of flexible CIS research at ISET", NASA Document ID:19950014096, accession No: 95N-20512, available from NASA Center for AeroSpace Information, and B.M. Basol et al., "Modules and flexible cells of CuInSe2", Proceedings of the 23rd Photovoltaic Specialists Conference, 1993, page 426). The conductive layer 746 may be in the form of a single layer or alternately it may comprise a stack of various sub-layers (not shown). Preferably, the conductive layer comprises at least one diffusion barrier layer that prevents diffusion of impurities from the flexible foil substrate 745 into the layers to be electrodeposited and into the CIGS(S) layer during its formation. Materials of the conductive layer 746 include but are not limited to Ti, Mo, Cr, Ta, W, Ru, Ir, Os, and compounds such as nitrides and oxy-nitrides of these materials. Preferably, the free surface 746A of the conductive layer 746 comprises at least one of Ru, Ir and Os for better nucleation of the electroplated layers. After electrodepositing the Cu, Ga and In layers, the final structure of the flexible foil base coated by the stacked precursor is shown in Fig. 7B. As can be seen from this figure, a Cu layer 750 is first electroplated on the free surface 746A. Then a Ga layer 751 is electrodeposited, followed by an In layer 752. As explained before, the order and nature of this stack may be changed by changing the deposition sequence and the thickness of each layer is selected to attain a targeted Cu/(Ga+In) molar ratio and a Ga/(Ga+In) molar ratio.

In this example electrodeposition is carried out on the free surface 746A of the conductive layer 746. The back surface 745B of the flexible foil substrate 745 may preferably be covered with a secondary layer 747 (shown with dotted line) to protect the flexible foil substrate 745 during electrodeposition as well as annealing/reaction steps that will follow to form the CIGS(S) compound, or to avoid buckling of the flexible foil substrate 745. It is important that the material(s) of the secondary layer 747 be stable in chemistries of the Cu, In and Ga plating baths, i.e. not dissolve into and contaminate such baths, and also be resistant to reaction with Group VIA elements. Materials that can be used in the secondary layer 747 include but are not limited to Ru, Os, Ir, Ta, W etc. The secondary layer 747 has an outer surface 747A that is exposed to the electroplating electrolytes or baths and other process environment present for the formation of CIGS(S) compound. Although Fig. 7B shows that the Cu, Ga and In layers are coated on one side of the flexible foil base 722, it is possible to deposit such stacks on both sides of a base to fabricate solar cells on both faces.

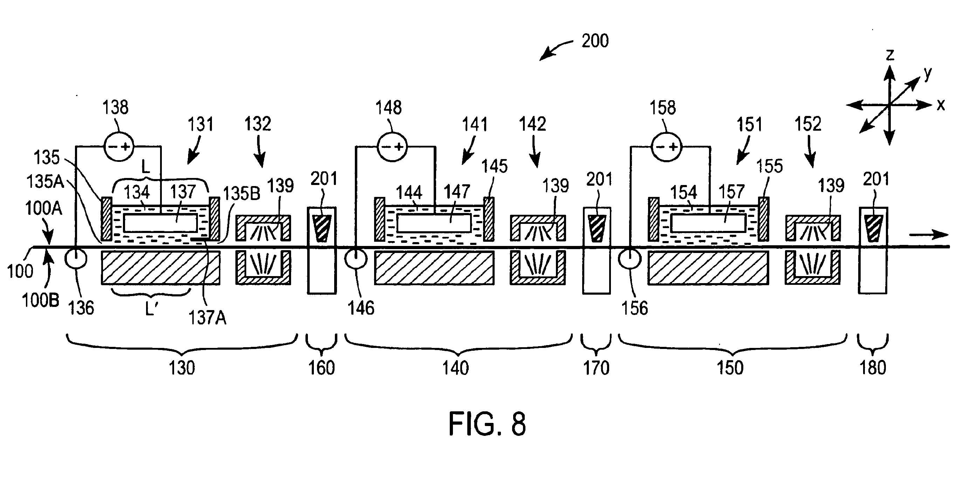

Fig. 8 shows in more detail a cross sectional view of an exemplary system 200 that may be used to grow a Cu/Ga/In precursor stack on a base 100 such as a flexible foil base of Fig. 7A. The system 200 comprises a Cu-processing-unit 130, a Ga-processing-unit 140, an In-processing-unit 150, a Cu-metrology-station 160, a Ga-metrology-station 170 and an In-metrology-station 180. The Cu-processing-unit 130 may comprise a Cu electroplating unit 131 and a Cu cleaning unit 132. The Ga-processing-unit 140 may comprise a Ga electroplating unit 141 and a Ga cleaning unit 142. The In-processing-unit 150 may comprise an In electroplating unit 151 and an In cleaning unit 152.

The Cu electroplating unit 131 comprises a Cu plating bath 134, which may be circulated between a Cu plating reservoir 135 and a chemical cabinet (not shown) through solution inlet and outlet tubes (not shown) on the Cu plating reservoir 135. The Cu plating bath 134 or solution or electrolyte may be filtered and replenished during circulation or while in the chemical cabinet. Measurement and control of various bath parameters, such as additive content, Cu content, temperature, pH etc. may be continuously or periodically carried out within the chemical cabinet to assure stability of the Cu deposition process. The exemplary system of Fig. 8 deposits Cu, Ga and In on the front surface 100A of the base 100. The front surface 100A preferably comprises at least one of Ru, Os and Ir. Electrical connection to the base 100 may be achieved by various means including through rollers, brushes etc. The electrical contacts may be touching the base 100 at, at least part of its back surface 100B or front surface 100A. Preferably, contacts to the front surface 100A are made at the two edges avoiding physical contact with most of the front surface 100A which may be damaged or contaminated by the electrical contact(s). One preferred method comprises making electrical contact to the back surface 100B of the base 100 through at least one Cu plating contact roller 136, if the substrate of the base is conductive. A Cu plating anode 137 is placed in the Cu plating bath 134 and a Cu plating power supply 138 is provided to apply a potential difference between the Cu plating anode 137 and the electrical contact(s) such as the Cu plating contact roller 136, so that Cu is electroplated on a section of the top surface 100A that is exposed to the Cu plating bath 134 across from the Cu plating anode 137 as the base 100 is moved from left to right at a predetermined speed. After plating, the section with deposited Cu layer gets cleaned in the Cu cleaning unit 132 through use of water sprays 139 directed on both surfaces of the base 100. Air knives (not shown) may be used to partially or fully dry the surface of the plated Cu as well as the back side of the base 100 before the plated and cleaned section enters the Cu-metrology-station 160. A metrology tool 201 such as an XRF head or probe may be provided in the Cu-metrology-station 160. Similar metrology tools 201 may also be provided in the Ga-metrology-station 170 and In-metrology-station 180. The metrology tools 201 may be mounted on structures (not shown) and may be moved in x, y or z direction in proximity of the base 100 to collect data about plated material layer amount or thickness, or the plated stack thickness/composition as the base 100 is moved from left to right along the x axis.

After deposition of the Cu layer, the Cu plated section of the base 100 passes through the Cu cleaning unit and the Cu-metrology-station, and enters the Ga electroplating unit 141 of the Ga-processing-unit 140. The Ga electroplating unit 141 comprises a Ga plating bath 144, which may be circulated between a Ga plating reservoir 145 and a chemical cabinet (not shown) through solution inlet and outlet tubes (not shown) on the Ga plating reservoir 145. The Ga plating bath 144 or solution or electrolyte may be filtered and replenished during circulation or while in the chemical cabinet. Measurement and control of various bath parameters, such as additive content, Ga content, temperature, pH etc. may be continuously or periodically carried out within the chemical cabinet to assure stability of the Ga deposition process. Electrical connection to the base 100 or the already plated Cu layer may be achieved by various means including through rollers, brushes etc. One preferred method comprises making electrical contact to the back surface 100B of the base 100 through at least one Ga plating contact roller 146, if the substrate of the base is conductive. A Ga plating anode 147 is placed in the Ga plating bath 144 and a Ga plating power supply 148 is provided to apply a potential difference between the Ga plating anode 147 and the Ga plating contact roller 146, so that Ga is electroplated on a section of the already Cu plated surface that is exposed to the Ga plating bath 144 across from the Ga plating anode 147 as the base 100 is moved from left to right at a predetermined speed. This way a Cu/Ga stack is formed on the base 100. After Ga plating, the plated section gets cleaned in the Ga cleaning unit 142 through use of water sprays 139. Air knives (not shown) may be used to partially or fully dry the surface of the plated Ga as well as the back side of the base 100 before the Ga plated and cleaned section enters the Ga-metrology-station 170. The Ga layer thickness as well as the underlying Cu layer thickness may be measured in the Ga-metrology-station 170 if a XRF probe or unit is employed.

After Ga deposition, cleaning and metrology, the base 100 with the electroplated Cu/Ga stack enters the In electroplating unit 151 of the In-processing-unit 150. The In electroplating unit 151 comprises an In plating bath 154, which may be circulated between an In plating reservoir 155 and a chemical cabinet (not shown) through solution inlet and outlet tubes (not shown) on the In plating reservoir 155. The In plating bath 154 or solution or electrolyte may be filtered and replenished during circulation or while in the chemical cabinet. Measurement and control of various bath parameters, such as additive content, In content, temperature, pH etc. may be continuously or periodically carried out within the chemical cabinet to assure stability of the In deposition process. Electrical connection to the base 100 or the already plated Cu/Ga stack may be achieved by various means including through rollers, brushes etc. One preferred method comprises making electrical contact to the back surface 100B of the base 100 through at least one In plating contact roller 156, if the substrate of the base is conductive. An In plating anode 157 is placed in the In plating bath 154 and an In plating power supply 158 is provided to apply a potential difference between the In plating anode 157 and the In plating contact roller 156, so that In is electroplated on a section of the already Cu and Ga plated surface that is exposed to the In plating bath 154 across from the In plating anode 157 as the base 100 is moved from left to right at a predetermined speed. This way a Cu/Ga/In stack is formed on the base 100. After In plating, the plated section gets cleaned in the In cleaning unit 152 through use of water sprays 139. Air knives (not shown) may be used to partially or fully dry the surface of the plated In as well as the back side of the base 100 before the In plated and cleaned section enters the In-metrology-station 180. The In layer thickness as well as the underlying Cu and Ga layer thicknesses may be measured in the In-metrology-station 180 if a XRF probe or unit is employed.

The continuous reel-to-reel electroplating technique of the present invention has several technical benefits. One of these benefits is the fact that each layer is electroplated on another layer that is freshly deposited and has a chemically active surface. Nucleation on such fresh surfaces is superior to nucleation on surfaces that are passivated as a result of oxidation or exposure to environment for extended periods of time after deposition. Another benefit is good thickness uniformity of the electroplated layer. Since the flexible base or substrate travels in front of the anodes during plating, its uniformity in the direction of travel, i.e. along its length, is excellent and very repeatable throughout the whole base. The uniformity along the width of the flexible base is the only factor to be optimized. One other benefit comes from the fact that the flexible base is always electrically "hot" when it enters a plating zone in a plating unit. Copper, In and Ga are different materials with different surface potentials when placed in plating electrolytes. For example, if Cu will be plated on an already plated Ga layer and if the Ga layer is dipped into the Cu plating electrolyte with no applied voltage, it is possible to have an exchange reaction between Ga surface and the Cu electrolyte. Such an exchange reaction may cause Ga to dissolve into the Cu plating electrolyte and Cu depositing (in an electroless manner) onto the Ga surface. It should be appreciated that such reactions would be detrimental to the control of crucial molar ratios such as the Cu/(Ga+In) ratio since these reactions are not well controlled. If the Ga surface enters into the Cu plating electrolyte with an appropriate cathodic voltage present on Ga, then exchange reaction cannot take place and Cu may be electrodeposited on Ga provided that Cu electrolyte is carefully selected. In the roll-to-roll approach described above, each section of the flexible base enters the plating solutions "hot", i.e. there is cathodic voltage on the base. Therefore, dissolution of films in various electrolytes is avoided.

As stated before, more processing-units may be added to the system 200 of Fig. 8, to obtain other precursor stacks, and more metrology-stations may be added to measure the thickness of each layer in the stack. For example, a Cu/Ga/In/Se stack may be obtained by adding a Se-processing-unit (not shown) after the In-metrology-station 180. The Se-processing-unit may comprise a Se electroplating unit and a Se cleaning unit. A Se-metrology-station (not shown) may then be added to measure the thickness of the electrodeposited Se film. It should be noted that metrology tools such as XRF (X-ray fluorescence) units have the capability of measuring the compositions or thicknesses of stacked layers comprising discrete films of various materials, as well as layers comprising mixtures or alloys of such materials. For example, these metrology tools can detect the amount of Cu and Ga in a Cu/Ga stacked layer as well as a Cu-Ga alloy layer and in the case of alloy layers these amounts may be represented as effective thicknesses of each material within the alloy layer. Therefore, the present invention may still be used even if electroplated stacks such as Cu/Ga stacks, Cu/Ga/In stacks etc. are heat treated and alloyed before they enter a metrology-station.

Composition control of a precursor stack comprising Cu, and at least one Group IIIA material such as In and/or Ga may be achieved in various ways using the present invention. Some of these approaches will now be discussed for preparing an exemplary Cu/Ga/In precursor stack with a target Cu/(Ga+In) ratio of 0.9 and target Cu, Ga and In thicknesses of 200 nm, 110 nm and 340 nm, respectively. It should be noted that for solar cells fabricated on CIGS(S) type absorber layers, one of the most important parameters affecting device efficiencies is the Cu/(Ga+In) ratio. Specifically, when this ratio exceeds 1.0 the efficiency value drops drastically because the excess Cu gives rise to phases such as Cu-Se and/or Cu-S, which have low resistivity and may introduce low shunt resistance in the solar cells. It is therefore crucial to assure that the Cu/(Ga+In) molar ratio does not exceed 1.0. It is, however, possible to grow Cu-rich CIGS(S) layers with controlled composition and then chemically etch (for example, using cyanide solutions) the excess Cu-Se and/or Cu-S phases bringing the Cu/(Ga+In) ratio down to around 1.0 before fabricating solar cells on the absorber layers.

If the Cu/(In+Ga) ratio of the solar cell absorber layer is kept under control, its total thickness may be changed, for example by at least +/- 10%, without affecting the device efficiencies. The Ga/(Ga+In) ratio is also important to control, but it may be changed, for example by up to +/- 10% without adversely affecting the efficiency. Taking into consideration the points in the above discussion, the present invention can be used in controlling the Cu/(In+Ga) and Ga/(Ga+In) molar ratios to different degrees in the following manner:

In a first approach, the thickness of the Cu layer electroplated on a segment of the base in the Cu-processing-unit 130 may be measured at the Cu-metrology-station 160. If this thickness value is outside a range defined by an upper limit and a lower limit, a signal may be sent to the Ga electroplating unit 141 to either increase or decrease the amount of Ga plating with respect to the nominal value that is expected to yield the exemplary target of 110 nm. For the exemplary Cu target thickness of 200 nm the upper and lower limits of the Cu thickness may be 205 nm and 195 nm, respectively. As an example, if the measured Cu thickness is 190 nm, the Ga plating power supply 148 may be sent a signal to reduce the Ga plating current density by about 200÷190= 1.05 when the segment enters the Ga electroplating unit 141. If the measured Cu thickness is 210 nm, the Ga plating current density may be increased by about 210÷200=1.05 times. Again, the increase of the current density may be timed so that the change is made when the segment enters the Ga electroplating unit 141 and Ga electroplating initiates. After Ga electroplating, the plated Ga layer thickness may be measured at the Ga-metrology-station 170. It should be noted that the metrology tool 201 at the Ga-metrology-station 170 may provide the thickness information about the underlying Cu layer also. Once the actual Ga thickness is measured, or the Cu/Ga molar ratio is measured, a computer or control unit may calculate the required thickness of In to be deposited in the In electroplating unit 150 to achieve the exemplary Cu/(Ga+In) ratio target of 0.9. For this purpose, a signal may be sent to the In plating power supply 158 to increase or decrease the current density that is expected to yield the originally targeted In thickness of 340 nm, so that the In thickness is adjusted to reach or get close to the targeted Cu/(Ga+In) ratio. As can be seen from this example, this approach fundamentally aims to obtain a targeted Cu/(In+Ga) ratio rather than to obtain the targeted thicknesses of Cu, Ga and In layers. The thicknesses of the Cu and Ga layers are actually measured and therefore the possible error in the final Cu/(Ga+In) molar ratio is minimized, the only error being due to the possible inaccuracy of the In layer thickness. This is, of course, better than the case of taking no measurements where inaccuracies in the deposited thickness of each layer may accumulate and cause the Cu/(In+Ga) ratio to miss the targeted value or even exceed 1.0. It should be noted that an In-metrology-station 180 provided after the In-processing-unit 150 may measure the In thickness over the Cu/Ga layers or even the Cu/(In+Ga) ratio to confirm the final composition. There may also be at least one tuning station (not shown) after the In-metrology-station to add more In onto the already plated Cu/Ga/In stack or to etch and remove In from the already plated Cu/Ga/In stack to meet the target Cu/(In+Ga) ratio. This approach of using tuning stations is detailed more in U.S. Provisional Application Serial No. 60/744,252 filed April 4, 2006 entitled "Composition Control for Photovoltaic Thin Film Manufacturing".

In another approach, the Cu-metrology-station 160 may not be used. Ga-metrology-station 170 may measure the Ga and Cu thicknesses within the Cu/Ga stack and send a signal to the In plating power supply 158 to control the deposited In thickness as described above.

In yet another approach, control of the electroplating power supplies may be carried out in a way to reach the targeted Cu, Ga and In thicknesses as well as the Cu/(In+Ga) ratio. For example, when the thickness of the Cu electroplated segment is measured at the Cu-metrology-station 160, a signal may be sent to the Cu plating power supply 138 to adjust the Cu plating current density to achieve a targeted Cu thickness. If the measured Cu thickness is larger than the targeted thickness, the current density is reduced. If the measured Cu thickness is smaller than the targeted thickness the current density may be increased. This way, the thickness of the plated Cu is kept near the target value. Similar approach may be used for Ga and In plating to keep the thicknesses of all layers in a stack at or near the targeted values. It should be noted that, this approach does not attempt to correct the thickness of a layer already deposited on a segment of the base. Rather, it aims to control the thickness of the layer that will be deposited on later segments of the base. In this approach metrology or thickness measurement may be carried out continuously or intermittently.

The film thickness control approaches summarized above may also be mixed in improving the performance of a system. In other words, one approach may be used for Cu thickness control, whereas another one may be employed for In and/or Ga film thickness controls. If a certain step of the process, for example the Cu electroplating step, is very stable and provides repeatable Cu thickness for a pre-determined plating current density and base speed, then a metrology-station may not be used for that step.

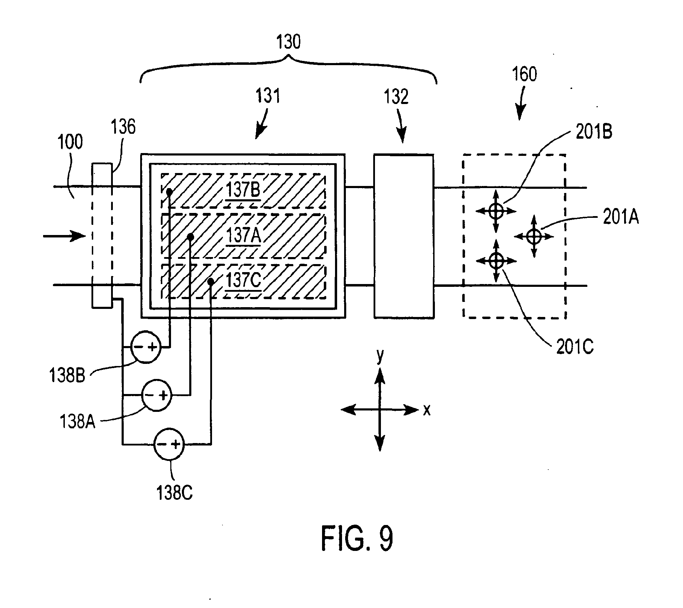

It is possible to employ multiple metrology tools in any of the metrology-stations and to control segmented anodes in electroplating units using such metrology tools. For example, Fig. 9 shows a top view of a process unit and a metrology-station, such as a Cu-processing-unit 130 comprising a Cu electroplating unit 131 and a Cu cleaning unit 132; and a Cu-metrology-station 160. There may be more than one metrology tool in the Cu-metrology-station 160 as is shown in Fig. 9. The first metrology tool 201A may be placed to measure the Cu thickness in the central region of the base 100 and the data collected by the first metrology tool 201 A may be used to control a first Cu plating power supply 138A connected to a first Cu plating anode segment 137A that provides plating current to the central region of the base 100. Similarly, a second metrology tool 201 B and a third metrology tool 201 C may be placed to measure the Cu thickness in the two edge regions of the base 100 and the data collected by these metrology tools may be used to control a second Cu plating power supply 138B and a third Cu plating power supply 138C, connected to a second Cu plating anode segment 137B and a third Cu plating anode segment 137C, respectively. This way, the edge to center Cu thickness uniformity may be improved on the base and the target thickness may be achieved over the whole surface of the base. For example, increased plating current density applied by the first Cu plating power supply 138A would increase the Cu thickness at the central region of the base 100 and increased plating current density provided by the second Cu plating power supply 138B and/or the third Cu plating power supply 138B would increase the Cu thickness at the edge regions of the base. It should be noted that the metrology tools 201 A, 201 B, 201 C may be moved in x, y directions. Other motions such as circular etc. movements may also be imparted to any of these metrology tools. Such movements define which regions of the base 100 are included in the collected thickness data. The base 100 moves in the x direction during electroplating and metrology at a predetermined speed which may be in the range of 0.1-5 cm/sec. Therefore, the thickness data collected by moving metrology tool(s) is an average value over several points on the base 100, unless the metrology tool(s) are moved at the same velocity and direction as the base 100.

It should be noted that the measurements in the metrology tools may be made continuously or intermittently, and therefore the control of the various plating power supplies may be done continuously or intermittently, for example every 10 seconds or every 60 seconds etc. Although in these examples the plating current densities were changed to achieve the targeted thicknesses or electroplated stack compositions, it is also possible to change the speed of the base 100 to control a plated material thickness. At a given plating current density and in a fixed length of a plating cell or unit, the thickness of the plated material would be smaller as the speed of the base 100 is increased. In a roll-to-roll process, however, changing the speed of the base 100 would affect the thicknesses of all the layers plated. This needs to be taken into consideration in designing the control approach that employs varying speed as one of the parameters to vary deposited film thickness. In another embodiment, changing the thickness of an electroplated film on a moving substrate may be achieved by changing an effective electroplating length of the plating cell through which the substrate moves for deposition. For example, referring back to Fig. 8, the length of the Cu plating cell or the Cu electroplating unit 131 is "L". A region at the front surface 100A of the base 100 entering the Cu electroplating unit 131 through an inlet slit 135A, starts plating when it is exposed to the Cu plating bath 134 and a plating current passes from the Cu plating anode 137 to the region. Deposition on the region continues until it exits the Cu electroplating unit 131 through an exit slit 135B. Therefore, the thickness of the Cu film deposited on the region may be reduced if an anode shadow piece 137A is introduced between the Cu plating anode 137 and the front surface 100A of the base 100. As shown in Fig. 8, depending on the length of the anode shadow piece 137A the "effective plating length" may be reduced to a new value of " L' ". If the anode shadow piece 137A is extendable then the amount of shadowing it provides can be varied even during the plating process and therefore the deposited film thickness may be manipulated. For example, a signal coming from a metrology station to reduce the deposited Cu thickness may either cause the Cu deposition current density to be lowered, or the anode shadow piece 137A to extend, or both.

In the above discussion we described roll-to-roll systems that electroplate all components of a precursor stack comprising Cu and at least one of Ga and In. This is the preferred method because it avoids multiple handling of the electroplated layers and provides electroplating on freshly deposited, active surfaces. However, the invention may also be applied to systems that electrodeposit individual layers or some of the layers of a given stack. For example, if the desired stack is a Cu/Ga/In stack, a first system may be used to deposit the Cu layer on a base. A second system may then electroplate a Ga layer over the Cu layer and a third system may electroplate an In layer over the Cu/Ga stack. In this case the composition/thickness control may be simpler since both electroplating current density variation and base speed variation may easily be used to control the thickness of a single layer. It is, of course, possible to electroplate two of the layers in a first system and the third layer in a separate system. For example, a first system may deposit the Cu layer and a second system may deposit the Ga and In layers. Alternately, a first system may deposit a Cu/Ga stack and a second system may deposit the top In layer.

It is also possible that instead of pure elements of Cu, In and Ga, the present invention may electroplate alloys or mixtures in the electroplating units and sense the compositions of these alloys or mixtures at the metrology-stations. Accordingly, precursor stacks comprising alloy layers or sub-layers may be obtained. Such stacks include, but are not limited to Cu-Ga/In, Cu-In/Ga, Cu-Ga/Ga/In, Cu/In-Ga, Cu-In/Ga/Cu etc., where Cu-Ga is an alloy or mixture of Cu and Ga, Cu-In is an alloy or mixture of In and Cu and In-Ga is an alloy and mixture of In and Ga. Although the most common form of a base used in solar cell fabrication is a flexible foil, it is possible to have a base in the form of a wire to manufacture, for example, cylindrical devices. In fact wires may have many different cross sectional shapes. The roll-to-roll processing approaches of the present invention are applicable to processing of any flexible base including those in the form of wires.

Once the precursor stacks, alloys or mixtures, or the "metal precursor/Group VIA material" stacks (such as a Cu/Ga/In/Se stack) of the present invention are formed, reaction or further reaction of these layers with Group VIA materials may be achieved by various means. For example, these layers may be exposed to Group VIA vapors at elevated temperatures. These techniques are well known in the field and they involve heating the layers to a temperature range of 350-600 °C in the presence of at least one of Se vapors, S vapors, and Te vapors provided by sources such as solid Se, solid S, solid Te, H₂Se gas, H₂S gas etc. for periods ranging from 5 minutes to 1 hour. In another embodiment a layer or multi layers of Group VIA materials may be further deposited on the metallic precursor layers and then heated up in a furnace or in a rapid thermal annealing furnace and like. Group VIA materials may be evaporated on, sputtered on or plated on the metallic precursor layers in a separate process unit. Alternately inks comprising Group VIA nano particles may be prepared and these inks may be deposited on the precursor layers or stacks to form a Group VIA material layer comprising Group VIA nano particles. Dipping, spraying, doctor-blading or ink writing techniques may be employed to deposit such layers. Reaction may be carried out at elevated temperatures for times ranging from 1 minute to 60 minutes depending upon the temperature. As a result of reaction, the Group IBIIIAVIA compound is formed. It should be noted that reaction chambers may also be added to the systems of the present invention to carry out the whole process in-line so that the flexible foil base with a fully formed CIGS(S) layer on its surface may be rolled onto a return spool 21 after electroplating and reaction steps.

Solar cells may be fabricated on the Group IBIIIAVIA compound layers of then present invention using materials and methods well known in the field. For example a thin (<0.1 microns) CdS layer may be deposited on the surface of the compound layer using the chemical dip method. A transparent window of ZnO may be deposited over the CdS layer using MOCVD or sputtering techniques. A metallic finger pattern is optionally deposited over the ZnO to complete the solar cell.

Although the present invention is described with respect to certain preferred embodiments, modifications thereto will be apparent to those skilled in the art.

## Claims

1. A method of electroplating a stacked layer of a plurality of films in a plurality of sequentially disposed electroplating units onto a continuously moving roll-to-roll sheet comprising the steps of:
continuously moving the roll-to-roll sheet through each of the plurality of sequentially disposed electroplating units so that continuous portions of a top surface of the roll-to-roll sheet are positioned for electroplating to occur thereover when disposed in each of the electroplating units;
continuously electroplating each one of the films over the top surface of the roll-to-roll sheet using each of the electroplating units as the roll-to-roll sheet moves therethrough, wherein the plurality of films include Cu, In and Ga elements; and
detecting a thickness and/or the composition of at least one of the films electroplated over a portion of the roll-to-roll sheet and generating a thickness signal corresponding thereto;
wherein the step of continuously electroplating includes adjusting the thickness of each of the films toward a predetermined thickness value for that film using the thickness signal for that film for a subsequent portion of the roll-to-roll sheet that follows the portion of the roll-to-roll sheet,
wherein the step of continuously electroplating adjusts the thickness of each of the films toward the predetermined thickness value for that film using the thickness signal for that film for the subsequent portion of the roll-to-roll sheet that follows the portion of the roll-to-roll sheet; and
wherein the step of detecting the thickness detects the thickness of each of the films.

2. The method according to claim 1 wherein the plurality of sequentially disposed electroplating units comprise at least one Cu electroplating unit, at least one Ga electroplating unit and at least one In electroplating unit.

3. The method according to claim 1 wherein the step of detecting is performed using X-ray fluorescence.

4. The method according to claim 1 wherein the step of adjusting alters a deposition current density used by the electroplating unit based upon the thickness signal, thereby adjusting the thickness of the subsequent portion of the film.

5. The method according to claim 1 wherein the step of adjusting alters an effective electroplating length used by the electroplating unit based upon the thickness signal, thereby adjusting the thickness of the subsequent portion of the film.

6. The method according to claim 1 wherein the step of detecting detects the thickness of the film at a plurality of locations across a width of the continuously moving roll-to-roll sheet to obtain a corresponding plurality of thickness signals;
wherein the step of adjusting adjusts the thickness of the film toward the predetermined thickness value using the plurality of thickness signals for a subsequent portion of the roll-to-roll sheet that follows the portion of the roll-to-roll sheet, such that the thickness is adjusted taking into consideration the location of the detecting.

7. The method according to claim 6 wherein the corresponding plurality of thickness signals each control a current density of a corresponding plurality of anodes for the step of adjusting.

8. The method according to claim 6 wherein the corresponding plurality of thickness signals each control an effective electroplating length of a corresponding plurality of anodes for the step of adjusting.

9. The method according to claim 7 wherein the step of detecting is performed using X-ray fluorescence.

10. The method according to claim 1 wherein the step of continuously electroplating includes,
and
after the step of detecting, tuning the plurality of films based on the amount of each of the elements deposited so that the stacked layer of the plurality of films has a predetermined molar ratio range of the elements.

11. The method according to claim 10 wherein the step of tuning deposits another film that includes one of the elements used for the predetermined molar ratio range.

12. The method according to claim 11 wherein the step of tuning deposits the another film using at least one of the plurality of sequentially disposed electroplating units.

13. The method according to claim 10 wherein the step of tuning removes a portion of a top one of the plurality of films.

14. The method according to claim 13 wherein the step of tuning removes the portion using at least one of the plurality of sequentially disposed electroplating units.

15. The method according to claim 10 wherein the step of detecting is performed using X-ray fluorescence.

16. The method according to claim 10 wherein the step of detecting occurs a plurality of times, respectively after each of the plurality of films has been applied, and further including a step of obtaining an actual molar ratio range from measurements obtained in each of the plurality of detecting steps.

17. The method according to claim 10 wherein the step of depositing uses electroplating in one of the plurality of sequentially disposed electroplating units that includes a bath, and the step of tuning includes the step of electroplating out of another one of the plurality of sequentially disposed electroplating units that includes another bath that is different than the bath.

18. The method according to claim 1 wherein the step of continuously electroplating includes
continuously electroplating a first film of the plurality of films onto the top surface of the continuously moving roll-to-roll sheet;
wherein the step of detecting includes detecting a thickness of the first film and generating a thickness signal corresponding thereto;
wherein the step of continuously electroplating further includes continuously electroplating a second film of the plurality of films over the first film, the second film having a composition that is different from the first film, and wherein a thickness of the electroplated second film is controlled by the thickness signal of the first film.

19. The method according to claim 18 wherein the first film includes at most two of the Cu, In and Ga elements, and wherein the second film includes at least one of the Cu, In and Ga elements that was not included in the first film.

20. The method according to claim 18 wherein the control by the thickness signal results in a substantially same molar ratio of a first element in the first film to a second element in the second film at substantially each location along the moving substrate.

21. The method according to claim 18 wherein the step of detecting is performed using X-ray fluorescence.

22. The method according to claim 18 wherein the first film is comprised of at least a first sub -film and second sub-film, each of the first and second sub-films being separately electroplated;
wherein the step of detecting detects the thickness of both sub-films at the same time, thereby resulting in a first sub-film thickness signal and a second sub-film thickness signal; and
wherein the first sub-film thickness signal and the second sub-film thickness signal are both used to generate the thickness signal used in the step of continuously electroplating the second film.

23. The method according to claim 22 wherein the step of detecting is performed using X-ray fluorescence.

24. The method according to claim 18 further including the steps of:
continuously electroplating a third film onto the second film using an electroplating unit as the roll-to-roll sheet moves therethrough; and
detecting a thickness of the third film electroplated onto a portion of the second film and generating another thickness signal corresponding thereto;
wherein the step of continuously electroplating the third film includes the step of adjusting the thickness of the third film toward a predetermined thickness value using the another thickness signal for a subsequent portion of the roll-to-roll sheet that follows the portion of the roll-to-roll sheet.

25. The method according to claim 24 wherein both steps of detecting are performed using X-ray fluorescence.

26. The method according to claim 18 wherein the step of detecting detects the thickness of the first film at a plurality of locations across a width of the continuously moving roll-to-roll sheet to obtain a corresponding plurality of thickness signals;
wherein the step of adjusting adjusts the thickness of the second film using the plurality of thickness signals for a subsequent portion of the roll-to-roll sheet that follows the portion of the roll-to-roll sheet, such that the thickness is adjusted taking into consideration the location of the detecting.

27. The method according to claim 1 further including the step of applying Se to at least one of the plurality of films.

## Patentansprüche

1. Verfahren zum Galvanisieren einer gestapelten Schicht von mehreren Schichten in mehreren nacheinander angeordneten Galvanisierungseinheiten auf einem sich kontinuierlich bewegenden Rollenbogen, das die folgenden Schritte umfasst:
kontinuierliches Bewegen des Rollenbogens durch jede der mehreren nacheinander angeordneten Galvanisierungseinheiten, so dass kontinuierliche Teile einer oberen Fläche des Rollenbogens zum Galvanisieren darauf positioniert werden, wenn er in jeder der Galvanisierungseinheiten angeordnet wird;
kontinuierliches Galvanisieren jeder der Schichten auf der oberen Fläche des Rollenbogens unter Verwendung jeder der Galvanisierungseinheiten, wenn sich der Rollenbogen dort hindurch bewegt, wobei die mehreren Schichten Cu-, In- und Ga-Elemente enthalten; und
Feststellen einer Dicke und/oder der Zusammensetzung von mindestens einer der Schichten, die auf einem Teil des Rollenbogens galvanisiert wurde, und Erzeugen eines Dickensignals, das dieser entspricht;
wobei der Schritt des kontinuierlichen Galvanisierens das Einstellen der Dicke jeder der Schichten auf einen vorgegebenen Dickenwert für diese Schicht unter Verwendung des Dickensignals für diese Schicht für einen anschließenden Teil der Rollenbahn umfasst, der dem Teil der Rollenbahn folgt,
wobei der Schritt des kontinuierlichen Galvanisierens das Einstellen der Dicke jeder der Schichten auf einen vorgegebenen Dickenwert für diese Schicht unter Verwendung des Dickensignals für diese Schicht für den anschließenden Teil der Rollenbahn umfasst, der dem Teil der Rollenbahn folgt; und
wobei der Schritt des Feststellens der Dicke die Dicke jeder der Schichten feststellt.

2. Verfahren nach Anspruch 1, wobei die mehreren nacheinander angeordneten Galvanisiereinheiten mindestens eine Cu-Galvanisiereinheit, mindestens eine Ga-Galvanisiereinheit und mindestens eine In-Galvanisiereinheit umfassen.

3. Verfahren nach Anspruch 1, wobei der Schritt des Feststellens unter Verwendung von Röntgenfluoreszenz ausgeführt wird.

4. Verfahren nach Anspruch 1, wobei der Schritt des Einstellens eine Abscheidungsstromdichte ändert, die von der Galvanisiereinheit auf der Grundlage des Dickensignals verwendet wird, dadurch Einstellen der Dicke des nachfolgenden Teils der Schicht.

5. Verfahren nach Anspruch 1, wobei der Schritt des Einstellens eine effektive Galvanisierlänge ändert, die von der Galvanisiereinheit auf der Grundlage des Dickensignals verwendet wird, dadurch Einstellen des anschließenden Teils der Schicht.

6. Verfahren nach Anspruch 1, wobei der Schritt des Feststellens die Dicke der Schicht an mehreren Orten über eine Breite der sich kontinuierlich bewegenden Rollenbahn feststellt, um entsprechende mehrere Dickensignale zu erhalten;
wobei der Schritt des Einstellens die Dicke der Schicht auf den vorgegebenen Dickenwert unter Verwendung der mehreren Dickensignale für einen anschließenden Teil der Rollenbahn einstellt, der dem Teil der Rollenbahn folgt, so dass die Dicke unter Berücksichtigung des Ortes der Feststellung eingestellt wird.

7. Verfahren nach Anspruch 6, wobei die entsprechenden mehreren Dickensignale jeweils eine Stromdichte von entsprechenden mehreren Anoden für den Schritt des Einstellens steuern.

8. Verfahren nach Anspruch 6, wobei die entsprechenden mehreren Dickensignale jeweils eine effektive Galvanisierlänge von entsprechenden mehreren Anoden für den Schritt des Einstellens steuern.

9. Verfahren nach Anspruch 7, wobei der Schritt des Feststellens unter Verwendung von Röntgenfluoreszenz ausgeführt wird.

10. Verfahren nach Anspruch 1, wobei der Schritt des kontinuierlichen Galvanisieren umfasst,
und
nach dem Schritt des Feststellens Abstimmen der mehreren Schichten auf der Grundlage der Menge jedes der Elemente, die abgeschieden werden, so dass die gestapelte Schicht aus mehreren Schichten einen vorgegebenen Molverhältnisbereich der Elemente hat.

11. Verfahren nach Anspruch 10, wobei der Schritt des Abstimmens eine weitere Schicht abscheidet, die eines der Elemente umfasst, die für den vorgegebenen Molverhältnisbereich verwendet werden.

12. Verfahren nach Anspruch 11, wobei der Schritt des Abstimmens eine weitere Schicht abscheidet, die mindestens eine der mehreren nacheinander angeordneten Galvanisierungseinheiten verwendet.

13. Verfahren nach Anspruch 10, wobei der Schritt des Abstimmens einen Teil auf einer der mehreren Schichten entfernt.

14. Verfahren nach Anspruch 13, wobei der Schritt des Abstimmens den Teil entfernt, der mindestens eine der mehreren nacheinander angeordneten Galvanisierungseinheiten verwendet.

15. Verfahren nach Anspruch 10, wobei der Schritt des Feststellens unter Verwendung von Röntgenfluoreszenz ausgeführt wird.

16. Verfahren nach Anspruch 10, wobei der Schritt des Feststellens mehrmals auftritt, jeweils nachdem jede der mehreren Schichten aufgebracht wurde, und ferner einen Schritt des Erhaltens eines tatsächlichen Molverhältnisbereichs aus Messungen umfasst, der in jedem der mehreren Feststellungsschritte erhalten wurde.

17. Verfahren nach Anspruch 10, wobei der Schritt des Abscheidens das Galvanisieren in einer der mehreren nacheinander angeordneten Galvanisierungseinheiten verwendet, die ein Bad umfasst, und der Schritt des Abstimmens den Schritt des Galvanisierens in einer weiteren der mehreren nacheinander angeordneten Galvanisierungseinheiten umfasst, der ein weiteres Bad umfasst, das sich von dem Bad unterscheidet.

18. Verfahren nach Anspruch 1, wobei der Schritt des kontinuierlichen Galvanisierens Folgendes umfasst
kontinuierliches Galvanisieren einer ersten Schicht der mehreren Schichten auf der oberen Fläche der sich kontinuierlich bewegenden Rollenbahn;
wobei der Schritt des Feststellens das Feststellen einer Dicke der ersten Schicht und Erzeugen eines Dickensignals umfasst, das dieser entspricht;
wobei der Schritt des kontinuierlichen Galvanisierens ferner das kontinuierliche Galvanisieren einer zweiten Schicht der mehreren Schichten über der ersten Schicht umfasst, wobei die zweite Schicht eine Zusammensetzung hat, die sich von der der ersten Schicht unterscheidet, und wobei eine Dicke der galvanisierten zweiten Schicht durch das Dickensignal der ersten Schicht gesteuert wird.

19. Verfahren nach Anspruch 18, wobei die erste Schicht höchstens zwei aus den Elementen Cu, In und Ga umfasst und wobei die zweite Schicht mindestens eins der Elemente Cu, In und Ga umfasst, das nicht in der ersten Schicht enthalten ist.

20. Verfahren nach Anspruch 18, wobei die Steuerung durch das Dickensignal zu einem im Wesentlichen selben Molverhältnis eines ersten Elementes in der ersten Schicht zu einem zweiten Element in der zweiten Schicht an im Wesentlichen jedem Ort entlang des sich bewegenden Substrats führt.

21. Verfahren nach Anspruch 18, wobei der Schritt des Feststellens unter Verwendung von Röntgenfluoreszenz ausgeführt wird.

22. Verfahren nach Anspruch 18, wobei die erste Schicht zumindest aus einer ersten Teilschicht und einer zweiten Teilschicht besteht, wobei jede aus der ersten und zweiten Teilschicht separat galvanisiert wird;
wobei der Schritt des Feststellens die Dicke beider Teilschichten gleichzeitig feststellt, was zu einem ersten Teilschichtdickensignal und einem zweiten Teilschichtdickensignal führt; und
wobei das erste Teilschichtdickensignal und das zweite Teilschichtdickensignal beide zum Erzeugen des Dickensignals verwendet werden, welches im Schritt des kontinuierlichen Galvanisierens des zweiten Films verwendet wird.

23. Verfahren nach Anspruch 22, wobei der Schritt des Feststellens unter Verwendung von Röntgenfluoreszenz ausgeführt wird.

24. Verfahren nach Anspruch 18, das ferner die folgenden Schritte umfasst:
kontinuierliches Galvanisieren einer dritten Schicht auf der zweiten Schicht unter Verwendung einer Galvanisierungseinheit, während sich die Rollenbahn durch diese hindurch bewegt; und
Feststellen einer Dicke der dritten Schicht, die auf einen Teil der zweiten Schicht galvanisiert wurde, und Erzeugen eines weiteren Dickensignals, welches dieser entspricht;
wobei der Schritt des kontinuierlichen Galvanisierens der dritten Schicht den Schritt des Einstellens der Dicke der dritten Schicht auf einen vorgegebenen Dickenwert unter Verwendung des weiteren Dickensignals für einen anschließenden Teil der Rollenbahn umfasst, der dem Teil der Rollenbahn folgt.

25. Verfahren nach Anspruch 24, wobei beide Schritte des Feststellens unter Verwendung von Röntgenfluoreszenz ausgeführt werden.

26. Verfahren nach Anspruch 18, wobei der Schritt des Feststellens die Dicke der ersten Schicht an mehreren Orten über eine Breite der sich kontinuierlich bewegenden Rollenbahn feststellt, um entsprechende mehrere Dickensignale zu erhalten;
wobei der Schritt des Einstellens die Dicke der zweiten Schicht unter Verwendung der mehreren Dickensignale für einen anschließenden Teil der Rollenbahn einstellt, der dem Teil der Rollenbahn folgt, so dass die Dicke unter Berücksichtigung des Ortes der Feststellung eingestellt wird.

27. Verfahren nach Anspruch 1, das ferner den Schritt des Aufbringens von Se auf mindestens eine der mehreren Schichten umfasst.

## Revendications

1. Procédé d'électroplaquage d'une couche empilée d'une pluralité de films dans une pluralité d'unités d'électroplaquage placées séquentiellement sur une feuille de rouleau à rouleau se déplaçant de manière continue comprenant les étapes consistant à _{:}
déplacer de manière continue la feuille de rouleau à rouleau à travers chaque unité de la pluralité d'unités d'électroplaquage placées séquentiellement de sorte que des parties continues d'une surface supérieure de la feuille de rouleau à rouleau soient positionnées pour que l'électroplaquage se produise dessus lorsqu'elle est placée dans chaque unité d'électroplaquage ;
électroplaquer de manière continue chacun des films sur la surface supérieure de la feuille de rouleau à rouleau en utilisant chaque unité d'électroplaquage au fur et à mesure que la feuille de rouleau à rouleau se déplace à travers celles-ci, la pluralité de films comprenant les éléments Cu, In et Ga ; et
détecter une épaisseur et/ou la composition d'au moins un des films électroplaqués sur une partie de la feuille de rouleau à rouleau et générer un signal d'épaisseur correspondant ;
dans lequel l'étape d'électroplaquage continu comprend l'ajustement de l'épaisseur de chacun des films par rapport à une valeur d'épaisseur prédéterminée pour ce film en utilisant le signal d'épaisseur pour ce film pour une partie suivante de la feuille de rouleau à rouleau qui suit la partie de la feuille de rouleau à rouleau,
dans lequel l'étape d'électroplaquage continu ajuste l'épaisseur de chacun des films par rapport à la valeur d'épaisseur prédéterminée pour ce film en utilisant le signal d'épaisseur pour ce film pour une partie suivante de la feuille de rouleau à rouleau qui suit la partie de la feuille de rouleau à rouleau ; et
dans lequel l'étape de détection de l'épaisseur détecte l'épaisseur de chacun des films.

2. Procédé selon la revendication 1, dans lequel la pluralité d'unités d'électroplaquage placées de manière séquentielle comprend au moins une unité d'électroplaquage de Cu, au moins une unité d'électroplaquage de Ga et au moins une unité d'électroplaquage d'In.

3. Procédé selon la revendication 1, dans lequel l'étape de détection est réalisée en utilisant une fluorescence des rayons X.

4. Procédé selon la revendication 1, dans lequel l'étape d'ajustement modifie une densité de courant de dépôt utilisée par l'unité d'électroplaquage en se basant sur le signal d'épaisseur, permettant ainsi d'ajuster l'épaisseur de la partie suivante du film.

5. Procédé selon la revendication 1, dans lequel l'étape d'ajustement modifie une longueur d'électroplaquage efficace utilisée par l'unité d'électroplaquage en se basant sur le signal d'épaisseur, permettant ainsi d'ajuster l'épaisseur de la partie suivante du film.

6. Procédé selon la revendication 1, dans lequel l'étape de détection détecte l'épaisseur du film en une pluralité d'emplacements sur une largeur de la feuille de rouleau à rouleau se déplaçant de manière continue pour obtenir une pluralité correspondante de signaux d'épaisseur ;
dans lequel l'étape d'ajustement ajuste l'épaisseur du film par rapport à la valeur d'épaisseur prédéterminée en utilisant la pluralité de signaux d'épaisseur pour une partie suivante de la feuille de rouleau à rouleau qui suit la partie de la feuille de rouleau à rouleau, de sorte que l'épaisseur soit ajustée en prenant en considération l'emplacement de la détection.

7. Procédé selon la revendication 6, dans lequel la pluralité correspondante de signaux d'épaisseur contrôle pour chaque signal une densité de courant d'une pluralité correspondante d'anodes pour l'étape d'ajustement.

8. Procédé selon la revendication 6, dans lequel la pluralité correspondante de signaux d'épaisseur contrôle pour chaque signal une longueur d'électroplaquage efficace d'une pluralité correspondante d'anodes pour l'étape d'ajustement.

9. Procédé selon la revendication 7, dans lequel l'étape de détection est réalisée en utilisant une fluorescence des rayons X.

10. Procédé selon la revendication 1, dans lequel l'étape d'électroplaquage continu comprend, après l'étape de détection, une étape consistant à ajuster la pluralité de films en fonction de la quantité de chacun des éléments déposés de sorte que la couche empilée de la pluralité de films a une plage de rapport molaire prédéterminée des éléments.

11. Procédé selon la revendication 10, dans lequel l'étape d'ajustement dépose un autre film qui comprend l'un des éléments utilisés pour la plage de rapport molaire prédéterminée.

12. Procédé selon la revendication 11, dans lequel l'étape d'ajustement dépose l'autre film en utilisant au moins une unité de la pluralité d'unités d'électroplaquage placées de manière séquentielle.

13. Procédé selon la revendication 10, dans lequel l'étape d'ajustement élimine une partie d'un film du dessus de la pluralité de films.

14. Procédé selon la revendication 13, dans lequel l'étape d'ajustement élimine la partie utilisant au moins une unité de la pluralité d'unités d'électroplaquage placées de manière séquentielle.

15. Procédé selon la revendication 10, dans lequel l'étape de détection est réalisée en utilisant une fluorescence des rayons X.

16. Procédé selon la revendication 10, dans lequel l'étape de détection produit une pluralité de temps, respectivement après l'application de chaque film de la pluralité de films, et comprend en outre une étape d'obtention d'une plage de rapport molaire réelle à partir des mesures obtenues dans chaque étape de la pluralité d'étapes de détection.

17. Procédé selon la revendication 10, dans lequel l'étape de dépôt utilise l'électroplaquage dans une unité de la pluralité d'unités d'électroplaquage placées de manière séquentielle qui comprend un bain, et l'étape d'ajustement comprend l'étape de retrait de l'électroplaquage d'une autre unité de la pluralité d'unités d'électroplaquage placées de manière séquentielle qui comprend un autre bain qui est différent du bain.

18. Procédé selon la revendication 1, dans lequel l'étape d'électroplaquage continu comprend les étapes consistant à
électroplaquer de manière continue un premier film de la pluralité de films sur la surface supérieure de la feuille de rouleau à rouleau se déplaçant de manière continue ;
dans lequel l'étape de détection comprend la détection d'une épaisseur du premier film et la production d'un signal d'épaisseur correspondant ;
dans lequel l'étape d'électroplaquage continu comprend en outre l'électroplaquage continu d'un deuxième film de la pluralité de films sur le premier film, le deuxième film comprenant une composition qui est différente de celle du premier film, et dans lequel une épaisseur du deuxième film électroplaqué est contrôlée par le signal d'épaisseur du premier film.

19. Procédé selon la revendication 18, dans lequel le premier film comprend au moins deux éléments choisis parmi les éléments Cu, In et Ga, et dans lequel le deuxième film comprend au moins un élément choisi parmi les éléments Cu, In et Ga qui n'est pas inclus dans le premier film.

20. Procédé selon la revendication 18, dans lequel le contrôle par le signal d'épaisseur donne un rapport molaire sensiblement le même d'un premier élément dans le premier film sur un second élément dans le deuxième film au niveau de sensiblement chaque emplacement sur le substrat se déplaçant.

21. Procédé selon la revendication 18, dans lequel l'étape de détection est réalisée en utilisant une fluorescence des rayons X.

22. Procédé selon la revendication 18, dans lequel le premier film se compose d'au moins un premier sous-film et un second sous-film, les premier et second sous-films étant chacun électroplaqués de manière séparée ;
dans lequel l'étape de détection détecte l'épaisseur des deux sous-films en même temps, donnant un signal d'épaisseur du premier sous-film et un signal d'épaisseur du second sous-film ; et
dans lequel le signal d'épaisseur du premier sous-film et le signal d'épaisseur du second sous-film sont tous les deux utilisés pour produire le signal d'épaisseur utilisé dans l'étape d'électroplaquage continu du deuxième film.

23. Procédé selon la revendication 22, dans lequel l'étape de détection est réalisée en utilisant une fluorescence des rayons X.

24. Procédé selon la revendication 18, comprenant en outre les étapes consistant à :
électroplaquer de manière continue un troisième film sur le deuxième film en utilisant une unité d'électroplaquage au fur et à mesure que la feuille de rouleau à rouleau se déplace dans celle-ci ; et
détecter une épaisseur du troisième film électroplaqué sur une partie du deuxième film et générer un autre signal d'épaisseur correspondant ;
dans lequel l'étape d'électroplaquage continu du troisième film comprend l'étape d'ajustement de l'épaisseur du troisième film par rapport à une valeur d'épaisseur prédéterminée en utilisant l'autre signal d'épaisseur pour une partie suivante de la feuille de rouleau à rouleau qui suit la partie de la feuille de rouleau à rouleau.

25. Procédé selon la revendication 24, dans lequel les deux étapes de détection sont réalisées en utilisant une fluorescence des rayons X.

26. Procédé selon la revendication 18, dans lequel l'étape de détection détecte l'épaisseur du premier film au niveau d'une pluralité d'emplacements sur une largeur de la feuille de rouleau à rouleau se déplaçant de manière continue afin d'obtenir une pluralité correspondante de signaux d'épaisseur ;
dans lequel l'étape d'ajustement ajuste l'épaisseur du deuxième film en utilisant la pluralité de signaux d'épaisseur pour une partie suivante de la feuille de rouleau à rouleau qui suit la partie de la feuille de rouleau à rouleau, de sorte que l'épaisseur soit ajustée en tenant compte de l'emplacement de la détection.

27. Procédé selon la revendication 1, comprenant en outre l'étape consistant à appliquer du Se sur au moins un film de la pluralité de films.
